# EUROPEAN PATENT APPLICATION

(11) **EP 4 841 386 A1**
(43) Date of publication of application: **18.11.2026**
(21) Application number: 26176833.7
(22) Date of filing: 06.05.2026
(51) Int. Cl.: G06F 1/10, G06F 30/396, H03K 19/003

(54) **VERTICALLY INTEGRATED CLOCK DISTRIBUTION NETWORK**

(30) Priority: 16.05.2025 US 202519210958
(71) Applicant: Avago Technologies International Sales Pte. Limited, Singapore 768923 (SG)
(72) Inventor: Lee, Chang-Hyeon, Lake Forest, 92630 (US)
(74) Representative: Bosch Jehle Patentanwaltsgesellschaft mbH

(57) **Abstract**

The present disclosure provides an integrated circuit comprising a first inductor trace and a second inductor trace arranged in a spiral configuration and disposed in a first metal layer. A first clock line is coupled to the first inductor trace and a second clock line is coupled to the second inductor trace, wherein the first clock line and second clock line are disposed in a second metal layer. The integrated circuit includes a crossing region where the first clock line and the second clock line extend under the first and second inductor traces. This configuration enables vertical integration of inductor and clock routing structures, allowing for efficient use of chip area while maintaining signal integrity in high-frequency clock distribution networks.

## Description

The present disclosure relates to integrated circuit design, and more particularly, to integrated inductors and clock routing paths in multi-layer metal structures.

Integrated circuits continue to evolve, with increasing demands for higher performance, lower power consumption, and smaller form factors. Clock distribution networks play a crucial role in synchronizing operations across various components of an integrated circuit. Current Mode Logic (CML) has emerged as a preferred approach for high-speed clock distribution due to its superior noise immunity and reduced voltage swing requirements. CML clock distribution networks typically employ differential signaling to minimize common-mode noise and achieve higher operating frequencies. As clock frequencies increase and circuit densities grow, maintaining signal integrity and minimizing skew become increasingly challenging.

Current clock distribution architectures often struggle to efficiently route highfrequency signals over long distances while managing power consumption and electromagnetic interference. Additionally, the integration of clock distribution components with other circuit elements can lead to layout constraints and potential performance trade-offs. These challenges highlight the need for innovative approaches to clock routing and signal distribution in advanced integrated circuit designs.

According to an aspect of the invention, an integrated circuit is provided, comprising:
a first inductor trace and a second inductor trace arranged in a spiral configuration and disposed in a first metal layer;
a first clock line coupled to the first inductor trace and a second clock line coupled to the second inductor trace, wherein the first clock line and second clock line are disposed in a second metal layer; and
a crossing region where the first clock line and the second clock line extend under the first and second inductor traces.

Advantageously:
the first inductor trace and the second inductor trace cross each other within the crossing region;
a first via couples the first inductor trace from the first metal layer to the second metal layer;
the portion of the first inductor trace in the second metal layer passes under the second inductor trace in the first metal layer; and
a second via couples the first inductor trace from the second metal layer to the first metal layer.

Advantageously:
the first clock line and the second clock line comprise widened portions within the crossing region; and
the first and second via are between the widened portions of the first clock line and the second clock line.

Advantageously:
the first inductor trace and the second inductor trace include a central region;
the first clock line and the second clock line extend under the central region;
the first inductor trace and the second inductor trace are positioned within the central region; and
there is no overlap between the first inductor trace and the second inductor trace and the first clock line and the second clock line within the central region.

Advantageously:
within the central region, the first inductor trace is adjacent to the first clock line; and
within the central region, the second inductor trace is adjacent to the second clock line.

Advantageously, the integrated circuit further comprises an inductor side shield including:
a Vss trace disposed in the second metal layer; and
a Vdd trace disposed in a third metal layer below the second metal layer.

Advantageously, the integrated circuit further comprises bottom shields coupled to the Vdd trace of the inductor side shield.

Advantageously, the integrated circuit further comprises clock line side shields coupled to the Vss trace of the inductor side shield.

According to an aspect, a device is provided, comprising:
an integrated circuit including:
a substrate;
core logic circuitry disposed on the substrate;
a plurality of phase-locked loops (PLLs); and
clock routing circuits onfigured to provide PLL signals to channel clock generating circuitry;
wherein at least one of the clock routing circuits comprises:
   a first inductor trace and a second inductor trace arranged in a spiral configuration and disposed in a first metal layer;
   a first clock line coupled to the first inductor trace and a second clock line coupled to the second inductor trace, wherein the first clock line and second clock line are disposed in a second metal layer; and
   a crossing region where the first clock line and the second clock line extend under the first and second inductor traces.

Advantageously:
the first inductor trace and the second inductor trace cross each other within the crossing region;
a first via couples the first inductor trace from the first metal layer to the second metal layer;
the portion of the first inductor trace in the second metal layer passes under the second inductor trace in the first metal layer; and
a second via couples the first inductor trace from the second metal layer to the first metal layer.

Advantageously:
the first clock line and the second clock line comprise widened portions within the crossing region; and
the first and second via are between the widened portions of the first clock line and the second clock line.

Advantageously:
the first inductor trace and the second inductor trace include a central region;
the first clock line and the second clock line extend under the central region;
the first inductor trace and the second inductor trace are positioned within the central region; and
there is no overlap between the first inductor trace and the second inductor trace and the first clock line and the second clock line within the central region.

Advantageously:
within the central region, the first inductor trace is adjacent to the first clock line; and
within the central region, the second inductor trace is adjacent to the second clock line.

Advantageously, the at least one clock routing circuit further comprises an inductor side shield including:
a Vss trace disposed in the second metal layer; and
a Vdd trace disposed in a third metal layer below the second metal layer.

Advantageously, the at least one clock routing circuit further comprises bottom shields coupled to the Vdd trace of the inductor side shield.

Advantageously, the plurality of PLLs and the plurality of clock routing circuits are disposed around a periphery of the core logic circuitry.

According to an aspect, a non-transitory computer-readable medium is provided comprising stored instructions to manufacture a circuit, the circuit comprising:
a first inductor trace and a second inductor trace arranged in a spiral configuration and disposed in a first metal layer;
a first clock line coupled to the first inductor trace and a second clock line coupled to the second inductor trace, wherein the first clock line and second clock line are disposed in a second metal layer; and
a crossing region where the first clock line and the second clock line extend under the first and second inductor traces.

Advantageously:
the first inductor trace and the second inductor trace cross each other within the crossing region;
a first via couples the first inductor trace from the first metal layer to the second metal layer;
a portion of the first inductor trace in the second metal layer passes under the second inductor trace in the first metal layer;
a second via couples the first inductor trace from the second metal layer to the first metal layer;
the first clock line and the second clock line comprise widened portions within the crossing region; and
the first and second via are between the widened portions of the first clock line and the second clock line.

Advantageously:
the first inductor trace and the second inductor trace include a central region;
the first clock line and the second clock line extend under the central region;
the first inductor trace and the second inductor trace are positioned within the central region; and
there is no overlap between the first inductor trace and the second inductor trace and the first clock line and the second clock line within the central region.

Advantageously: within the central region, the first inductor trace is adjacent to the first clock line; and within the central region, the second inductor trace is adjacent to the second clock line.

### BRIEF DESCRIPTION OF THE DRAWINGS

The disclosure will become fully understood from the following detailed description, taken in conjunction with the accompanying figures, wherein like reference numerals refer to like elements, in which:
FIG. 1A is a block diagram of an integrated circuit with core logic and peripheral clock routing circuitry, according to an exemplary embodiment;
FIG. 1B is a block diagram of west clock routing circuits of the integrated circuit of FIG. 1A, according to an exemplary embodiment;
FIG. 1C is a block diagram of an integrated circuit region showing clock routing channel circuits, according to an exemplary embodiment;
FIGS. 1D-1E are circuit diagrams of a CML clock distribution network, according to an exemplary embodiment;
FIGS. 2A-2B are top-down views of an inductor structure and a clock routing structure, respectively, according to an exemplary embodiment;
FIG. 2C is a top-down view of clock path circuitry integrating an inductor with a clock routing path, according to an exemplary embodiment;
FIG. 2D is a top-down view of a portion of the combined circuitry of FIG. 2C, according to an exemplary embodiment; and
FIG. 3 is a block diagram of a system for implementing clock path circuitry, according to an exemplary embodiment.

### DETAILED DESCRIPTION

Before turning to the figures, which illustrate the exemplary embodiments in detail, it should be understood that the application is not limited to the details or methodology set forth in the description or illustrated in the figures. It should also be understood that the terminology is for the purpose of description only and should not be regarded as limiting.

In some cases, Current Mode Logic (CML) clock distribution networks may utilize inductors to enhance signal integrity and extend bandwidth. These inductors are typically placed alongside clock routing paths to provide inductive peaking, which can help compensate for capacitive loading effects. However, conventional placement of inductors on the side of clock paths may lead to several challenges. For example, this arrangement may consume significant chip area, potentially limiting the overall circuit density. Additionally, side-placed inductors may introduce asymmetry in the clock distribution network, potentially affecting signal balance and timing relationships between different clock domains. In some examples, the physical separation between inductors and clock lines may also result in increased parasitic effects and reduced efficiency of the inductive compensation.

The described technology may address these challenges by vertically integrating inductors with clock routing paths in a multi-layer metal structure. In some cases, this approach allows for the placement of spiral inductors directly above the CML clock lines, utilizing upper metal layers of the integrated circuit. For example, the inductor structures may be fabricated in a first metal layer (e.g., an uppermost metal layer), while the clock lines are implemented in a lower metal layer (e.g., the next layer or another lower layer below the first metal layer). This vertical integration may reduce the footprint of the clock distribution network over clock distribution networks with conventional side-by-side placement of CML clock lines and inductors. For instance, the described technology may potentially improve area utilization by 30-40% compared to conventional placement. In some examples, the vertical arrangement may also avoid asymmetries associated with the conventional side-by-side placement, potentially enhancing signal integrity and reducing skew. Additionally, the closer proximity between inductors and clock lines may allow for more efficient inductive compensation, potentially extending the bandwidth of the clock distribution network while minimizing power consumption.

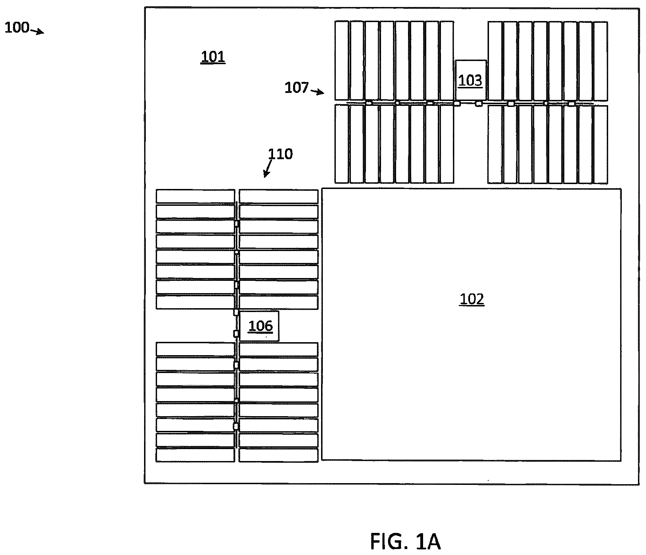

FIG. 1A illustrates an integrated circuit device 100. The integrated circuit 100 may include a substrate 101 with core logic circuitry 102 positioned in a central region. For example, the integrated circuit 100 could be implemented as a switch application-specific integrated circuit (ASIC) using 3nm technology to support high-bandwidth data routing in data center and cloud computing environments. The switch ASIC may utilize a network processor architecture with multiple packet processing engines to handle the high-bandwidth data routing requirements.

The integrated circuit 100 may include multiple phase-locked loops (PLLs) , such as PLL 103 and PLL 106. PLLs 103, 106 may be positioned at different locations to provide clock signals to various regions of the integrated circuit 100. Implementations may employ any suitable PLL design, such as using a fractional-N architecture with a voltage-controlled oscillator (VCO). The integrated circuit 100 may include clock routing circuits , such as north-south clock routing circuits 107, and east-west clock routing circuits 110 surrounding the core logic circuitry 102. For instance, each clock routing circuit may utilize differential current-mode logic (CML) signaling and may provide clock signal transmission over any routing distances, such as between 100 µm to 1 cm or greater.

The terms "north-south" and "east-west" are used for ease of explanation and do not imply any specific orientation of the integrated circuit 100. For example, "north-south" may refer to a direction parallel to polysilicon (poly) lines within the IC and "east-west" may refer to a direction perpendicular to poly lines, or vice versa. Additionally, the terms do not imply rectilinearity or orthogonality, the north-south circuits 107 and east-west circuits 110 may be oblique to one another and/or may be arranged diagonally on the substrate 101. Further, the technology is not limited to two clock routing circuits and may be applied to circuits 100 having any number of such circuits (e.g., one clock routing circuit, four clock routing circuits, hundreds of clock routing circuits, etc.).

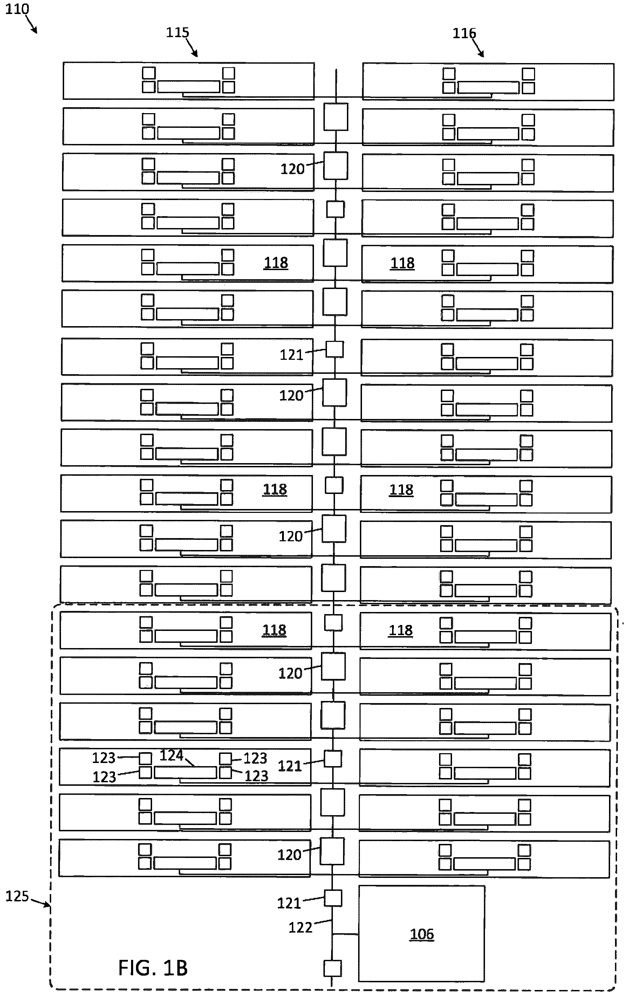

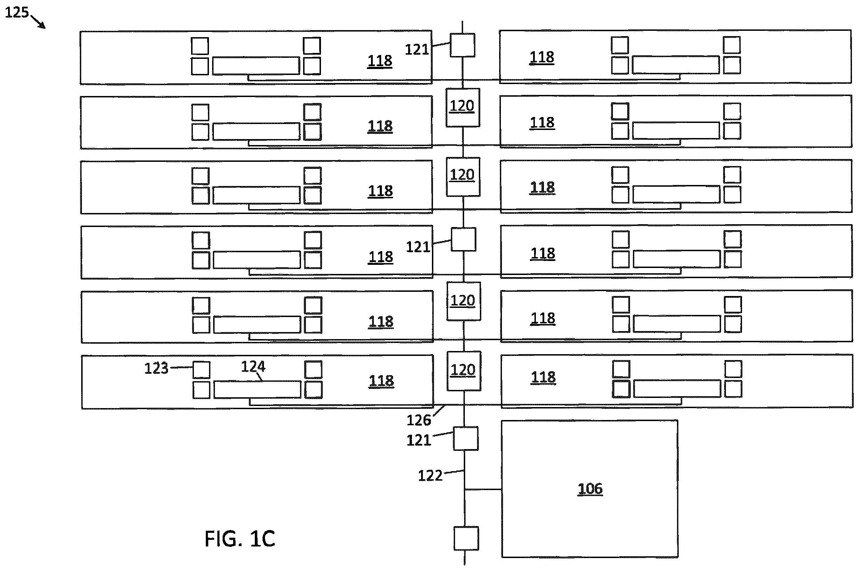

FIG. 1B and FIG. 1C illustrate block diagram views of portions of the clock routing circuits. For example, FIG. 1B depicts a portion of west clock routing circuits 110 that includes a left channel block 115 and a right channel block 116 arranged in a symmetrical configuration. In some examples, multiple clock routing channel circuits 118 are arranged in parallel rows extending vertically through the architecture. In such examples, the parallel arrangement may allow for efficient distribution of clock signals to multiple channels while maintaining consistent timing relationships. The clock routing channel circuits 118 may be implemented with any channel spacing providing suitable signal integrity and meeting crosstalk reduction requirements, such as between 25 µm to 75 µm. The clock routing channel circuits 118 may include primary input circuits 123 and clock generating circuits 124 for clocking signal transmission. For example, the primary input circuits 123 could be implemented using CML-compatible differential D-type flip-flops with suitably short setup and hold times (e.g., on the order of 10 picoseconds) to maintain timing margins at high clock frequencies.

In some examples, inductor elements 120 are positioned at intervals along the clock routing paths, with CML drivers 121 integrated at specific points to facilitate signal distribution. For example, the inductor elements 120 may be implemented as spiral inductors fabricated in the upper metal layers (such as M19) of the integrated circuit to achieve high quality factors, e.g. between 4 and 6 (e.g., around 5) at the operating frequency range. CML clock paths 122 may extend between the circuits 118 to distribute clock signals to the clock routing channel circuits 118. For example, the CML clock paths 122 could be implemented using differential transmission lines with controlled impedance of approximately 100 ohms to maintain signal integrity. In some examples, the CML clock paths 122 may use side shields connected to power supply (Vdd) and ground (Vss) to minimize electromagnetic interference and maintain signal quality over long routing distances and/or at high switching speeds or clock frequencies.

FIG. 1C illustrates an integrated circuit region 125 encompassing a portion of the clock distribution structure, including PLL 106. In some examples, the architecture demonstrates a systematic layout where inductor elements 120 and CML drivers 121 are positioned at intervals along the distribution paths. For instance, the CML drivers 121 may be spaced apart (e.g., 250 µm or more) to provide signal regeneration at appropriate intervals along the clock distribution network. In some examples, each CML driver 121 may provide adequate signal swing (e.g., between 200-400 mV) while minimizing power consumption and providing common-mode rejection. For instance, CML driver 121 may have a tail current between 2-4 mA. In some cases, the inductor elements 120 may be positioned between CML drivers 121 to provide inductive peaking, which can extend the bandwidth of the clock distribution network by compensating for capacitive loading effects. As described further below, the inductor elements 120 may be vertically integrated with the clock routing paths to improve area utilization.

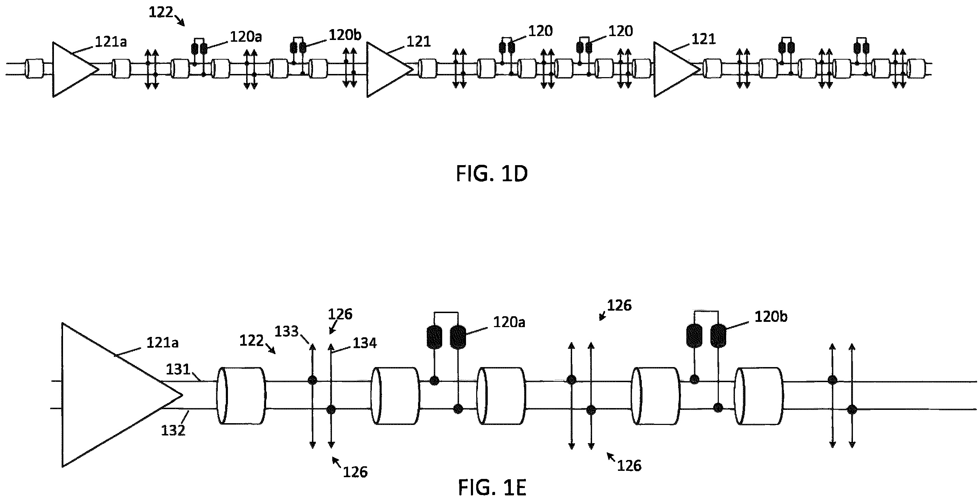

FIG. 1D and FIG. 1E illustrate circuit diagrams of a CML clock distribution network. For example, FIG. 1D shows a clock distribution architecture comprising multiple CML drivers 121 arranged in series along a CML clock path 122 and FIG. 1E shows a portion of the CML clock path 122. The clock path may comprise differential pairs 131, 132 and may include inductor elements 120 positioned at intervals between the CML drivers 121. For example, the inductor elements 120 may be implemented as spiral inductors (see below) with suitable values for the device's 100 operating frequency. For instance, inductances ranging from 800 pH to 1.5 nH may provide inductive peaking at operating frequencies between 10 and 20 Ghz. In some examples, the specific inductor values may be selected based on the capacitive loading at different points in the clock distribution network, with larger inductance values used at points with higher loading. Clock distribution nodes 126 may be arranged along the path to distribute clock signals. In some examples, the clock distribution nodes 126 may include buffering circuitry with controlled input capacitance to maintain signal integrity when driving multiple loads.

FIG. 1E depicts a detailed view of a portion of the clock distribution network. In some examples, a CML driver 121a includes current-mode outputs connected to a p-side clock line 131 and an n-side clock line 132. These clock lines may connect to subsequent p-side clock line 133 and n-side clock line 134 through clock distribution nodes 126. Inductors, such as a first inductor 120a and a second inductor 120b may be positioned along the current-mode clock paths to provide inductive compensation. As described above, the inductors 120 may have different inductances, for instance the first inductor 120a might have a value of 1.1 nH while the second inductor 120b may have a value of 1.3 nH, with both inductors having quality factors between around 5 at operating frequencies.

As an example, the integrated circuit 100 may have between 50 and 100 channels to support high-bandwidth data transfer. In this example, these channels may be arranged as a set of channels for receive (Rx) and a set of channels for transmit (Tx) functions, with each channel supporting multiple lanes to achieve data rates of 10+ Tbps. The PLLs may distribute clock signals that are used by the clock generating circuits 124 to generate the clocking signals for data transfer via the primary input circuits 123. For example, the PLLs could output differential CML clock signals with frequencies in the range of 10-20 GHz that are then buffered and distributed by the CML drivers 121 through the clock routing network. As an example, the PLLs may generate clock signals with jitter specifications of a few hundred femtoseconds RMS (or lower) to ensure adequate timing margins at the high data rates. The clock distribution network may be designed to add suitably small amounts additional jitter, for instance, less than 1 picosecond RMS of added jitter through the entire distribution path.

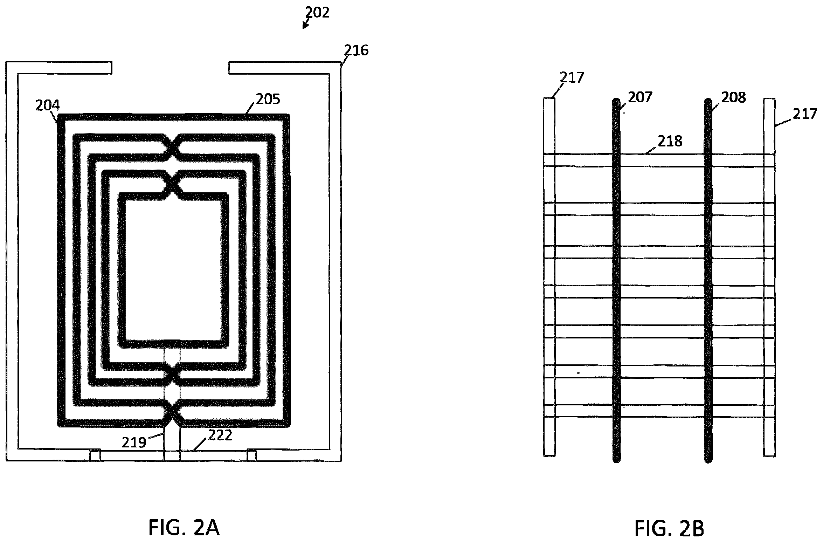

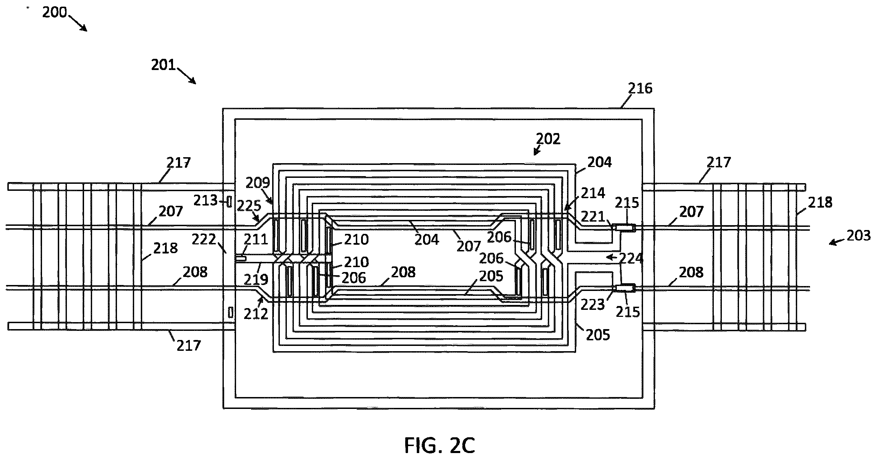

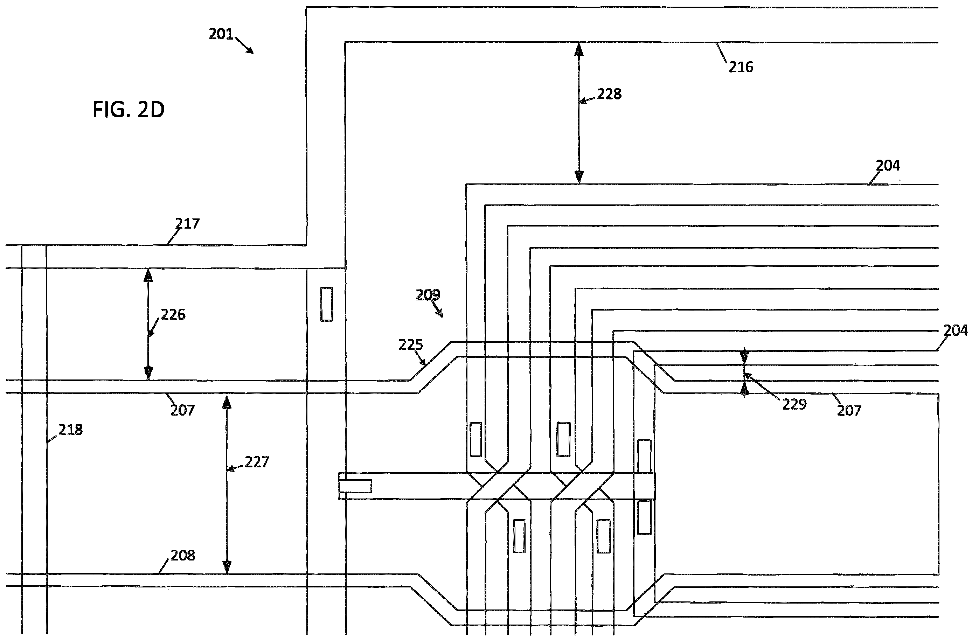

FIG. 2A-2D illustrate various aspects of clock path circuitry including spiral inductors that may be implemented in the integrated circuit 100. FIG. 2A depicts a top-down view of an inductor structure. FIG. 2B shows a top-down view of a clock routing structure. FIG. 2C provides a detailed top-down view of combined circuitry integrating the inductor and clock routing structures. FIG. 2D illustrates key spacing relationships within the combined circuitry. These figures demonstrate the vertical integration approach where inductor structures are positioned directly above clock routing paths to improve area utilization while maintaining signal integrity. For example, this vertical integration may allow for a reduction in the horizontal footprint of the clock distribution network while preserving the electrical characteristics of both the inductors and clock routing paths. For instance, the vertical integration approach may be particularly beneficial in the 3nm technology node, where metal layer stack-up includes multiple thick upper metal layers (such as M19) that are well-suited for implementing high-quality inductors with suitably low resistance.

The illustrated examples are described with respect to an IC 100 having 20 metal layers, labeled M0 through M19, where M0 is the metal layer closest to the silicon substrate of the IC and M19 is the metal layer farthest above the silicon substrate. However, the described technology is not limited to this specific metal layer configuration. For example, the principles and techniques discussed may be applied to ICs with fewer metal layers, such as 10 or 15 layers, or to ICs with more metal layers, such as 25 or 30 layers. In some cases, the specific metal layer used for various components (e.g., inductors, clock lines, shielding) may be adjusted based on the total number of available metal layers in a given IC design. For instance, in an IC with fewer metal layers, the inductor structures may be implemented in a proportionally lower metal layer while still maintaining vertical integration with the clock routing paths. While the examples described herein position the inductor on the uppermost metal layer (M19) and the clock lines on the next layer underneath (M18), in some examples, the vertical integration approach may be implemented using any suitable combination of metal layers. For example, the inductor could be implemented in a middle metal layer with the clock lines positioned in a layer above or below, provided that appropriate spacing and shielding are maintained to preserve signal integrity. FIG. 2A shows an inductor 202 formed by a p-side inductor trace 204 and an n-side inductor trace 205 arranged in a spiral configuration and disposed in a first metal layer. For example, the spiral configuration may utilize 5 turns with trace widths of 1-2 µm and spacing of 1-1.5 µm to achieve the target inductance values while maintaining a compact footprint. The specific dimensions and/or number of turns may be determined in various manners, such as via electromagnetic simulations.

The inductor 202 may be surrounded by an inductor side shield 216. In some examples, the inductor side shield 216 may be connected to power supply (Vdd) in metal layer M18 and ground (Vss) in metal layer M17 to provide electromagnetic isolation. FIG. 2B depicts a clock routing path 203 comprising a p-side clock line 207 coupled to the first inductor trace and an n-side clock line 208 coupled to the second inductor trace, wherein the clock lines are disposed in a second metal layer and run parallel to each other. For instance, the clock lines may be implemented as differential transmission lines with controlled characteristic impedance to maintain signal integrity (e.g., approximately 100 ohms). The clock lines may be surrounded by clock line side shields 217 and positioned above bottom shields 218. In some examples, the clock line side shields 217 may be connected to ground (Vss) to minimize electromagnetic interference and crosstalk.

In some examples, FIG. 2C illustrates clock path circuitry 200 showing combined circuitry 201 that integrates the inductor 202 with the clock routing path 203. The combined circuitry 201 may utilize a multi-layer metal stack to achieve vertical integration of the inductor and clock routing structures. For example, the metal stack may include M19 for the inductor traces, M18 for clock lines and Vdd side shields, M17 for Vss side shields, and M16 for bottom shields. The p-side clock line 207 and n-side clock line 208 may extend under the inductor 202 in crossing regions 209 and 214, where the first clock line and the second clock line extend under the first and second inductor traces. For example, the clock lines may be implemented in metal layer M18 while the inductor traces may be implemented in metal layer M19, allowing for vertical stacking of these structures with suitably low capacitive coupling between them.

In some examples, the inductor 202 may comprise a p-side inductor trace 204 and an n-side inductor trace 205 arranged in an interleaved spiral configuration. The two traces may be disposed in a first metal layer, such as M19, and may follow a spiral path that winds inward from the outer edges of the inductor structure. As the traces progress inward, they may cross each other at specific crossing regions. For instance, arrays of vias 206 (e.g., arrays of microvias or other small vias) may allow the p-side inductor trace 204 and n-side inductor trace 205 to cross over each other within these crossing regions. For instance, the via arrays 206 may provide a signal connection to metal layer M18 for the crossover points. The spiral configuration may culminate at the center, where the traces may join at connection points such as vias 210 and a ground trace 219, completing the electrical path of the inductor. In some cases, the central region may provide a floor plan space under which clock lines can be positioned, so that the clock lines are not overlapped by the inductor traces within the central region. The specific dimensions and number of turns in the spiral may be determined based on factors such as the desired inductance value, quality factor, and operating frequency range of the clock distribution network. In some examples, the spiral configuration may include a number of loops (e.g., 5 loops as illustrated) such that the p-side inductor trace 204 is positioned adjacent to the p-side clock line 207 within the central region, while the n-side inductor trace 205 is positioned adjacent to the n-side clock line 208 within the central region. In the illustrated example, the p-side clock line 207 and the n-side clock line 208 are coupled to the outer loops of their respective spiral inductors 204, 205. In further examples, any other suitable arrangement may be employed. For instance, the p-side clock line 207 and n-side clock line 208 may be coupled to the inner loops of their respective spiral inductor traces 204, 205. In these examples, the vias 210 may be disposed at the outer peripheries of the spiral inductor traces to couple the inductor traces to a ground trace 219.

In some examples, via arrays 206 may allow the p-side inductor trace 204 and n-side inductor trace 205 to cross over each other within the crossing regions 225, 214. For instance, the via arrays 206 may connect between metal layers M19 and M18 to enable the crossing of inductor traces while maintaining electrical continuity. In some examples, a first via array 206 couples the first inductor trace from the first metal layer to the second metal layer, the portion of the first inductor trace in the second metal layer passes under the second inductor trace in the first metal layer, and a second via array 206 couples the first inductor trace from the second metal layer to the first metal layer. In further examples, any suitable via architecture may be employed with adequate dimensions to provide signal paths with sufficient inductor Q values. In some examples, the clock lines may include widened portions within the crossing regions to accommodate the via arrays 206 used for inductor trace crossovers. For instance, the p-side clock line 207 and n-side clock line 208 may expand laterally in these regions, creating space between them for the via arrays 206 to be positioned. This expansion may support via arrays 206 having sufficient dimensions (e.g. array width and length) to provide a sufficiently low resistance for the induct meal line's interconnection between layers to provide a Q value meeting design requirements.

The inductor 202 may include a p-side inductor port 221 and an n-side inductor port 223 coupled to the p-side clock line 207 and n-side clock line 208, respectively, through vias 215. An inductor throat 224 may form a narrowed region separating the inductor traces from the clock lines. In some examples, the inductor throat 224 may be designed with specific dimensions to control the coupling between the inductor traces and clock lines, such as spacings between 0.5 µm to 2 µm.

For example, multiple vias such as via array 210, via array 211, and via array 213 may connect different metal layers of the circuitry. In some examples, these vias may be implemented as arrays of smaller vias to reduce resistance and improve reliability, with each array containing 4-9 individual vias depending on the current-carrying requirements. The design may incorporate several shielding elements, including the inductor side shield 216 surrounding the inductor structure, the clock line side shield 217 running alongside the clock lines, and bottom shields 218 providing additional electromagnetic isolation. For instance, the inductor side shield 216 may be implemented in metal layers M17 and M18, with M17 connected to ground (Vss) and M18 connected to power supply (Vdd). In some examples, the inductor side shield includes a Vss trace disposed in the second metal layer and a Vdd trace disposed in a third metal layer below the second metal layer. In some examples, this dual-layer shielding approach may provide more effective electromagnetic isolation than single-layer shielding. The bottom shields may be coupled to the Vdd trace of the inductor side shield. The clock line side shields may be coupled to the Vss trace of the inductor side shield. A p-n transition ground trace 219 may be integrated into the layout. In some examples, the p-n transition ground trace 219 may provide a controlled impedance environment for the transition between p-side and n-side signal paths, with dimensions to maintain the differential impedance through the transition region.

In some examples, multiple inductor designs with different dimensions may be created to provide a range of inductance values for different positions within the clock distribution network. For example, a set of different inductor designs with spiral lengths between 30 and 60 µm may be used to achieve the desired range of inductance values. In some examples, the inductor 202 may have a Q range of 4 to 6at operating frequencies. In some examples, the Q factor may be configured via design of the inductor geometry and shielding structures. As an example, the inductor 202 may have an inductance range of 800 pH to 2 nH for a circuit operating at frequencies between 10 GHz and 20GHz.

The clock routing circuitry may use different metal layers for various components. For example, metal layer M19 may be used for the inductor 202, M18 for clock lines and Vdd side shields, M17 for Vss side shields, and M16 for bottom shields. This multi-layer approach may allow for efficient use of integrated circuit real estate while providing effective electromagnetic isolation. In some examples, M19 may be the topmost metal layer with the greatest thickness (e.g., between 0.75 µm to 3 µm), making it suitable for the inductor traces to minimize resistance. In some examples, M18 may have intermediate thickness (e.g., between 0.5 µm to 2.25 µm) and be positioned directly below M19, making it appropriate for the clock lines. In some examples, M17 and M16 may be thinner layers (e.g., between 0.4 µm to 1.5 µm positioned further down in the metal stack, suitable for shielding structures. The specific metal layer thicknesses and spacing may be determined by the process technology used for fabrication, with the design configured for the available metal stack.

FIG. 2D illustrates spacing relationships within the combined circuitry 201 that may particularly impact circuit performance. A crossing region 209 may be evident where the p-side inductor trace 204 overlaps with the p-side clock line 207, demonstrating the vertical integration of these components. For instance, in this region, the inductor trace in metal layer M19 may pass directly over the clock line in metal layer M18, with careful design to minimize capacitive coupling between these structures. In some examples, the vertical separation between M19 and M18 may be approximately between 0.25 µm to 1.5 µm (e.g., 0.5-1 µm), depending on the specific process technology. A p-side expansion segment 225 may be a trace portion where the clock line widens. In some examples, the first clock line and the second clock line comprise widened portions within the crossing region, and the first and second via are between the widened portions of the first clock line and the second clock line. In some examples, this widening may be designed to reduce the resistance of the clock line in specific regions, such as where vias connect to other metal layers. In some examples, the width of the clock line may increase from a nominal value of approximately 1-2 µm to between 1.5 µm to 6 µm (e.g., 3-4 µm) in the expansion segment, with the specific dimensions selected to maintain controlled impedance while reducing resistance.

The figure shows various spacing relationships between components. For example, the side shield to clock line spacing 226 may be the distance between the shield and the clock line. In some examples, this spacing may be maintained at between 0.75 µm to 2.25 µm (e.g., 1.5 µm) to balance electromagnetic isolation with area efficiency. The p-n line spacing 227 may be the distance between complementary signal lines. For instance, this spacing may be set at between 1 µm to 3 µm to minimize cross-capacitive coupling while maintaining a compact layout. In some examples, this spacing may be twice the value of the spacing between a single clock line and its adjacent shield (e.g., d1 between 0.5 µm to 1.5 µm) to further reduce coupling between the differential signals. The side shield to inductor spacing 228 may be the distance between the shield and the edge of the inductor structure. In some examples, this spacing may be maintained at between 0.75 µm to 2.25 µm to preserve the inductor's Q factor by reducing eddy current losses in the shield. The inductor to clock line spacing 229 may be the distance (within the inner region of the inductor 202) between the inductor traces and the clock line traces. For example, this spacing may be set at between 0.5 µm to 1.5 µm to minimize capacitive coupling between the inductor and clock lines while maintaining a compact overall footprint.

The inductance of the inductor 202 may be tuned by configuring the length of the spiral (where length is the direction parallel to the clock lines). For example, a longer spiral path may result in higher inductance, while a shorter spiral path may result in lower inductance. In some examples, the inductor length may be varied from between 20 µm to 100 µm (e.g., 35 µm to 60 µm) for design of the inductor characteristics for different frequency ranges or loading conditions within the clock distribution network. For instance, inductors with higher inductance values may be positioned at points in the network with greater capacitive loading, while inductors with lower inductance values may be used at points with lighter loading. In some cases, each design may maintain the same overall width and shielding dimensions to simplify integration into the clock distribution network. In some examples, the first inductor trace and the second inductor trace include a central region, the first clock line and the second clock line extend under the central region, the first inductor trace and the second inductor trace are positioned within the central region, and there is no overlap between the first inductor trace and the second inductor trace and the first clock line and the second clock line within the central region. In some examples, within the central region, the first inductor trace is adjacent to the first clock line, and within the central region, the second inductor trace is adjacent to the second clock line. In some examples, the clock distribution network may utilize inductors with specific values to optimize signal integrity and timing characteristics. For instance, in FIG. 1D inductors with values such 1 ± α nH (with α between 0 and 0.5) may be placed along the clock path. These inductance values may be selected based on factors such as capacitive loading at different points in the network, the desired frequency response, and the need to maintain consistent signal quality across the entire distribution path.

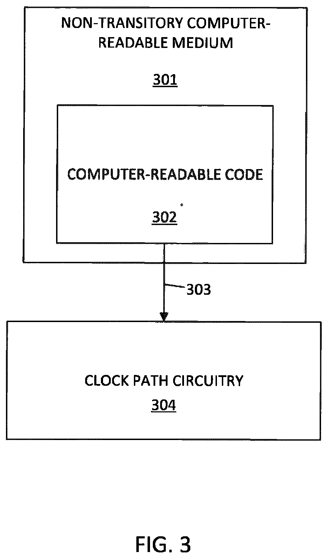

FIG. 3 illustrates a system for implementing the clock path circuitry described in previous figures. The system may include a non-transitory computer-readable medium 301 containing computer-readable code 302. For example, the computer-readable medium 301 could be implemented as a solid-state drive, hard disk drive, or other data storage device with capacities ranging from several gigabytes to multiple terabytes. In some examples, the computer-readable medium 301 may be a network-attached storage device accessible via a secure connection using protocols such as HTTPS or SSH. The computer-readable code 302 may comprise instructions for manufacturing the clock routing circuitry described in previous figures. For instance, the computer-readable code 302 may include hardware description language (HDL) files such as Verilog or VHDL, layout databases in formats such as GDSII or OASIS, or other digital representations of the circuit designs. In some examples, the computer-readable code 302 may also include scripts for design rule checking (DRC) and layout versus schematic (LVS) verification to ensure manufacturability.

In some examples, the computer-readable code 302 may be used in a manufacturing process 303 to produce clock routing circuitry 304. For example, the manufacturing process 303 could involve photolithography using extreme ultraviolet (EUV) lithography systems with numerical apertures of 0.33 or higher to achieve the fine feature sizes required by the 3nm process node. The process may also include etching using reactive ion etching (RIE) techniques, deposition using chemical vapor deposition (CVD) or atomic layer deposition (ALD), and other semiconductor fabrication techniques to create the physical structures described in previous figures. In some examples, the manufacturing process 303 may utilize a 3nm semiconductor process with a multi-layer metal stack including layers M16 through M19 for implementing the various components of the clock routing circuitry. The process may use copper damascene techniques for metal layers, with low-k dielectric materials having dielectric constants below 2.5 to minimize parasitic capacitance. The clock routing circuitry 304 may represent a physical implementation of the circuit designs encoded in the computer-readable code 302. For instance, the clock routing circuitry 304 may include the vertically integrated inductor and clock routing structures described in previous figures, fabricated using the specified metal layers and dimensions.

In some examples, the clock routing circuitry 304 produced by the manufacturing process 303 could be an implementation of the circuitry shown in FIGS. 2A-2D. For instance, the clock routing circuitry 304 may include the combined circuitry 201 that integrates the inductor 202 with the clock routing path 203. The manufactured circuitry may also include features such as the p-side inductor trace 204, n-side inductor trace 205, p-side clock line 207, and n-side clock line 208 as described in previous figures. In some examples, the clock routing circuitry 304 may be fabricated using a damascene process for the metal layers, with copper conductors having resistivities of less than 2 µΩ·cm and low-k dielectric materials with dielectric constants below 2.5 to minimize parasitic capacitance and resistance. The fabrication process may include multiple steps of photolithography, etching, deposition, and planarization to create the complex multi-layer structures required for the vertically integrated inductor and clock routing design. In some examples, the process may also include specialized steps for creating the via structures that connect different metal layers, with particular attention to minimizing the resistance of these connections.

In some examples, the clock routing circuitry 304 may be incorporated into an integrated circuit similar to the integrated circuit 100 illustrated in FIG. 1A. For example, the clock routing circuitry 304 could be part of the west clock routing circuits 110 or other clock routing circuits surrounding the core logic circuitry 102 on the substrate 101. In some examples, the clock routing circuitry 304 may be replicated multiple times around the periphery of the core logic circuitry 102 to provide comprehensive clock distribution to all regions of the integrated circuit 100. For instance, the design may be replicated with appropriate modifications to create the north clock routing circuits 107, east clock routing circuits 108, and south clock routing circuits 109. The clock routing circuitry 304 may be designed to interface with the PLLs (such as PLL 103, PLL 104, PLL 105, and PLL 106) to distribute their output clock signals throughout the integrated circuit 100. In some examples, the interface may include level-shifting and buffering circuitry to ensure proper signal levels and drive strength when connecting the PLL outputs to the CML clock distribution network.

The computer-readable code 302 may include representations of various circuit elements. For instance, in some examples, the computer-readable code 302 may include a standard cell representation for the combined circuitry 201. This standard cell representation could define the layout and electrical characteristics of the combined circuitry 201, including the arrangement of the inductor 202 and clock routing path 203. The standard cell may include pins or ports for connecting to other circuit elements, with defined electrical characteristics such as input capacitance and output impedance. In some examples, the computer-readable code 302 may include parameterized cells (p-cells) that allow for automated generation of the inductor structures with different dimensions to achieve various inductance values. These p-cells may accept parameters such as inductor length, number of turns, and trace width to generate custom inductor layouts designed for specific requirements. In some examples, the computer-readable code 302 may also include design rule checking (DRC) and layout versus schematic (LVS) verification scripts to ensure the manufacturability and correctness of the circuit designs. These scripts may verify compliance with process-specific design rules such as minimum feature sizes, spacing requirements, and density constraints.

In some examples, the computer-readable medium 301 may store multiple representations of the clock routing circuitry 304. For example, these representations could include schematic diagrams created using tools such as Cadence Virtuoso or Synopsys Custom Designer, layout files in formats such as GDSII or OASIS, netlists in SPICE or Verilog formats, or other formats used in integrated circuit design and manufacturing. In some examples, the representations may include SPICE models for circuit simulation with accurate parasitic extraction, GDSII or OASIS files for layout representation with sub-nanometer precision, and Verilog or VHDL code for behavioral modeling of the clock distribution network. The multiple representations may provide different levels of abstraction or detail for the clock routing circuitry 304, supporting various stages of the design and manufacturing process. For instance, schematic representations may be used during initial design and verification, while layout files may be used for physical implementation and manufacturing. In some examples, the computer-readable medium 301 may also store simulation results, such as time-domain and frequency-domain analyses of the clock distribution network, to validate the design before manufacturing.

In some examples, the described technology may be implemented using various types of integrated circuits and semiconductor processes. For example, the clock routing circuitry could be fabricated using 3nm, 5nm, 7nm or other advanced process nodes. The specific process node may be selected based on factors such as performance requirements, power consumption targets, and cost considerations.

In some cases, the clock distribution network may be designed to operate at different frequency ranges. For instance, while the examples described earlier focused on 12-16 GHz operation, the principles could be applied to networks operating at lower or higher frequencies. The inductor and clock line designs may be adjusted accordingly to optimize performance for the target frequency range.

The described technology may utilize different types of clock distribution architectures. For example, while current-mode logic (CML) drivers were described in previous examples, other driver types such as CMOS drivers or low-voltage differential signaling (LVDS) drivers could be employed in some implementations. The choice of driver technology may depend on factors such as power consumption, signal integrity requirements, and compatibility with other circuit components.

In some examples, the clock distribution network may incorporate additional circuit elements to enhance performance or functionality. For instance, programmable delay elements could be integrated to allow for fine-tuning of clock timing relationships. Multiplexers might be included to enable dynamic selection between multiple clock sources. Buffer stages could be added at strategic points in the network to maintain signal integrity over long routing distances.

The described technology may be applied to various types of integrated circuits beyond the switch ASIC example mentioned earlier. For instance, the clock distribution techniques could be utilized in microprocessors, graphics processing units (GPUs), field-programmable gate arrays (FPGAs), or other complex digital systems requiring precise clock distribution over large chip areas.

In some cases, the clock distribution network may be designed to support multiple clock domains operating at different frequencies. This could involve incorporating clock domain crossing circuits, such as synchronizers or clock gating logic, to manage the interfaces between different clock regions on the chip.

The described technology may employ various shielding and isolation techniques to minimize electromagnetic interference and crosstalk between clock lines and other sensitive circuits. For example, in addition to the side shields and bottom shields mentioned earlier, top shielding layers could be added in some implementations. Guard rings or deep trench isolation structures might be used to provide further electrical isolation between clock distribution components and adjacent circuitry.

The described technology may leverage advanced packaging techniques to optimize clock distribution. For instance, in 2.5D or 3D integrated circuit designs, clock signals might be routed through silicon interposers or using through-silicon vias (TSVs) to efficiently distribute clocks between stacked die or chiplets.

Those skilled in the art will appreciate the arrangement or interconnection of components such as "coupled," "connected," "on," "under," or similar wording allows for indirect connections, or intervening components or layers. Terms indicating orientation or relative position such as "above," "below," "top," "bottom," "upper," "lower," "vertical," "horizontal," "over," or similar terms are used with reference to the underlying substrate of the integrated circuit, and do not imply any particular physical orientation of the integrated circuit during operation, manufacturing, or use. For example, a component described as being "above" another component means the component is farther from the substrate than the other component in the stack-up direction, regardless of how the integrated circuit might be physically oriented.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

Similarly, when an element is referred to herein as being "disposed in" a metal layer, it is to be understood that the element is incorporated into one or more metal interconnect layers formed during a back end of line (BEOL) fabrication process or similar circuit fabrication process. In particular, the term "in" implies an association with a particular layer and does not imply a particular structure. For example, a trace "disposed in" a metal layer may comprise a metal (e.g., copper) deposited onto a lower layer (e.g., onto an etch stop layer or similar material deposited on a lower layer) and that spans the height of the layer. The metal layer may further comprise an insulator (e.g., a spin-on dielectric (SOD) or the like) that fills the space not occupied by metallization to form the metal layer. Similarly, vias may be described as "disposed in" one or more metal layers that they interconnect.

When first elements are described as located "around" a second element, it is to be understood that the first elements do not necessarily completely surround the second element. For instance, in FIG. 1A, the circuits 107 and 110 are disposed around the circuit 102 but do not completely surround the circuit 102. Additionally, the term does not imply a particular proximity between the first elements and the second element.

As used herein, unless otherwise limited or defined, "or" indicates a non-exclusive list of components or operations that may be present in any variety of combinations, rather than an exclusive list of components that may be present as alternatives to each other. For example, a list of "A, B, or C" indicates options of: A; B; C; A and B; A and C; B and C; and A, B, and C.

The term "or" is intended to indicate exclusive alternatives when preceded by terms of exclusivity, such as "either," "one of," or "exactly one of." A list preceded by "one or more" and including "or" to separate listed elements indicates options of one or more of any or all of the listed elements. For example, the phrases "one or more of A, B, or C," "at least one of A, B, or C", or "A, B, or C" indicate options of: one or more A; one or more B; one or more C; one or more A and one or more B; one or more B and one or more C; one or more A and one or more C; and one or more of each of A, B, and C. Similarly, a list preceded by "a plurality of" and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

The articles "a," "an," and "the" are intended to include the plural forms as well, unless the context clearly indicates otherwise.

Any mark, if referenced herein, may be common law or registered trademarks of third parties affiliated or unaffiliated with the applicant or the assignee. Use of these marks is by way of example and shall not be construed as descriptive or to limit the scope of disclosed or claimed embodiments to material associated with such marks.

The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Throughout the application, unless context indicates otherwise, ordinal numbers (e.g., first, second, third, etc.) may be used as an adjective for an element (i.e., any noun in the application). Although terms such as "first," "second," and "third" may be used herein to describe various members, components, regions, layers, or sections, these members, components, regions, layers, or sections are not to be limited by these terms. Rather, these terms are used to distinguish one member, component, region, layer, or section from another member, component, region, layer, or section. The use of ordinal numbers is not to imply or create any particular ordering of the elements nor to limit any element to being a single element unless expressly disclosed, such as by the use of the terms "before," "after," "single," and other such terminology. Rather, the use of ordinal numbers is to distinguish between the elements. By way of an example, a first element is distinct from a second element, and the first element may encompass more than one element and succeed (or precede) the second element in an ordering of elements. Thus, a first member, component, region, layer, or section referred to in examples described herein may also be referred to as a second member, component, region, layer, or section without departing from the teachings of the examples.

Embodiments of the described technology include the following:
Embodiment 1. An integrated circuit, comprising:
   a first inductor trace and a second inductor trace arranged in a spiral configuration and disposed in a first metal layer;
   a first clock line coupled to the first inductor trace and a second clock line coupled to the second inductor trace, wherein the first clock line and second clock line are disposed in a second metal layer; and
   a crossing region where the first clock line and the second clock line extend under the first and second inductor traces.
Embodiment 2. The integrated circuit of Embodiment 1, wherein:
   the first inductor trace and the second inductor trace cross each other within the crossing region;
   a first via couples the first inductor trace from the first metal layer to the second metal layer;
   the portion of the first inductor trace in the second metal layer passes under the second inductor trace in the first metal layer; and
   a second via couples the first inductor trace from the second metal layer to the first metal layer.
Embodiment 3. The integrated circuit of Embodiment 2, wherein:
   the first clock line and the second clock line comprise widened portions within the crossing region; and
   the first and second via are between the widened portions of the first clock line and the second clock line.
Embodiment 4. The integrated circuit of Embodiment 3, wherein:
   the first inductor trace and the second inductor trace include a central region;
   the first clock line and the second clock line extend under the central region;
   the first inductor trace and the second inductor trace are positioned within the central region; and
   there is no overlap between the first inductor trace and the second inductor trace and the first clock line and the second clock line within the central region.
Embodiment 5. The integrated circuit of Embodiment 4, wherein:
   within the central region, the first inductor trace is adjacent to the first clock line; and
   within the central region, the second inductor trace is adjacent to the second clock line.
Embodiment 6. The integrated circuit of Embodiment 1, further comprising an inductor side shield including:
   a Vss trace disposed in the second metal layer; and
   a Vdd trace disposed in a third metal layer below the second metal layer.
Embodiment 7. The integrated circuit of Embodiment 6, further comprising bottom shields coupled to the Vdd trace of the inductor side shield.
Embodiment 8. The integrated circuit of Embodiment 6, further comprising clock line side shields coupled to the Vss trace of the inductor side shield.
Embodiment 9. A device, comprising:
   an integrated circuit including:
   a substrate;
   core logic circuitry disposed on the substrate;
   a plurality of phase-locked loops (PLLs) disposed around a periphery of the core logic circuitry; and
   clock routing circuits disposed along edges of the core logic circuitry, wherein the clock routing circuits are configured to provide PLL signals to channel clock generating circuitry;
   wherein at least one of the clock routing circuits comprises:
      a first inductor trace and a second inductor trace arranged in a spiral configuration and disposed in a first metal layer;
      a first clock line coupled to the first inductor trace and a second clock line coupled to the second inductor trace, wherein the first clock line and second clock line are disposed in a second metal layer; and
      a crossing region where the first clock line and the second clock line extend under the first and second inductor traces.
Embodiment 10. The device of Embodiment 9, wherein:
   the first inductor trace and the second inductor trace cross each other within the crossing region;
   a first via couples the first inductor trace from the first metal layer to the second metal layer;
   the portion of the first inductor trace in the second metal layer passes under the second inductor trace in the first metal layer; and
   a second via couples the first inductor trace from the second metal layer to the first metal layer.
Embodiment 11. The device of Embodiment 10, wherein:
   the first clock line and the second clock line comprise widened portions within the crossing region; and
   the first and second via are between the widened portions of the first clock line and the second clock line.
Embodiment 12. The device of Embodiment 11, wherein:
   the first inductor trace and the second inductor trace include a central region;
   the first clock line and the second clock line extend under the central region;
   the first inductor trace and the second inductor trace are positioned within the central region; and
   there is no overlap between the first inductor trace and the second inductor trace and the first clock line and the second clock line within the central region.
Embodiment 13. The device of Embodiment 12, wherein:
   within the central region, the first inductor trace is adjacent to the first clock line; and
   within the central region, the second inductor trace is adjacent to the second clock line.
Embodiment 14. The device of Embodiment 9, wherein the at least one clock routing circuit further comprises an inductor side shield including:
   a Vss trace disposed in the second metal layer; and
   a Vdd trace disposed in a third metal layer below the second metal layer.
Embodiment 15. The device of Embodiment 14, wherein the at least one clock routing circuit further comprises bottom shields coupled to the Vdd trace of the inductor side shield.
Embodiment 16. The device of Embodiment 14, wherein the at least one clock routing circuit further comprises clock line side shields coupled to the Vss trace of the inductor side shield.
Embodiment 17. A non-transitory computer-readable medium comprising stored instructions to manufacture a circuit, the circuit comprising:
   a first inductor trace and a second inductor trace arranged in a spiral configuration and disposed in a first metal layer;
   a first clock line coupled to the first inductor trace and a second clock line coupled to the second inductor trace, wherein the first clock line and second clock line are disposed in a second metal layer; and
   a crossing region where the first clock line and the second clock line extend under the first and second inductor traces.
Embodiment 18. The non-transitory computer-readable medium of Embodiment 17, wherein:
   the first inductor trace and the second inductor trace cross each other within the crossing region;
   a first via couples the first inductor trace from the first metal layer to the second metal layer;
   a portion of the first inductor trace in the second metal layer passes under the second inductor trace in the first metal layer;
   a second via couples the first inductor trace from the second metal layer to the first metal layer;
   the first clock line and the second clock line comprise widened portions within the crossing region; and
   the first and second via are between the widened portions of the first clock line and the second clock line.
Embodiment 19. The non-transitory computer-readable medium of Embodiment 17, wherein:
   the first inductor trace and the second inductor trace include a central region;
   the first clock line and the second clock line extend under the central region;
   the first inductor trace and the second inductor trace are positioned within the central region; and
   there is no overlap between the first inductor trace and the second inductor trace and the first clock line and the second clock line within the central region.
Embodiment 20. The non-transitory computer-readable medium of Embodiment 19, wherein:
   within the central region, the first inductor trace is adjacent to the first clock line; and
   within the central region, the second inductor trace is adjacent to the second clock line.
Embodiments of the disclosure are described in the general context of method operations which may be implemented in one embodiment by a program product including machine-executable instructions, such as program code, for example, in the form of program modules executed by machines in networked environments.

It should be noted that although the flowcharts provided herein show a specific order of method steps, it is understood that the order of these operations may differ from what is depicted. Also two or more steps may be performed concurrently or with partial concurrence. Such variation will depend on the software and hardware systems chosen and on designer choice. It is understood that all such variations are within the scope of the disclosure.

The foregoing description of embodiments of the disclosure have been presented for purposes of illustration and description. It is not intended to be exhaustive or to limit the disclosure to the precise form disclosed, and modifications and variations are possible in light of the above teachings or may be acquired from practice of the disclosure. The embodiments were chosen and described in order to explain the principals of the disclosure and its practical application to enable one skilled in the art to utilize the disclosure in various embodiments and with various modifications as are suited to the particular use contemplated.

## Claims

1. An integrated circuit, comprising:
a first inductor trace and a second inductor trace arranged in a spiral configuration and disposed in a first metal layer;
a first clock line coupled to the first inductor trace and a second clock line coupled to the second inductor trace, wherein the first clock line and second clock line are disposed in a second metal layer; and
a crossing region where the first clock line and the second clock line extend under the first and second inductor traces.

2. The integrated circuit of claim 1, wherein:
the first inductor trace and the second inductor trace cross each other within the crossing region;
and/or a first via couples the first inductor trace from the first metal layer to the second metal layer;
and/or the portion of the first inductor trace in the second metal layer passes under the second inductor trace in the first metal layer; and/or a second via couples the first inductor trace from the second metal layer to the first metal layer.

3. The integrated circuit of claim 2, wherein:
the first clock line and the second clock line comprise widened portions within the crossing region; and
the first and second via are between the widened portions of the first clock line and the second clock line.

4. The integrated circuit of claim 3, wherein:
the first inductor trace and the second inductor trace include a central region;
the first clock line and the second clock line extend under the central region;
the first inductor trace and the second inductor trace are positioned within the central region; and
there is no overlap between the first inductor trace and the second inductor trace and the first clock line and the second clock line within the central region.

5. The integrated circuit of claim 4, wherein:
within the central region, the first inductor trace is adjacent to the first clock line; and
within the central region, the second inductor trace is adjacent to the second clock line.

6. The integrated circuit of any preceding claim, further comprising an inductor side shield including:
a Vss trace disposed in the second metal layer; and
a Vdd trace disposed in a third metal layer below the second metal layer.

7. The integrated circuit of claim 6, further comprising bottom shields coupled to the Vdd trace of the inductor side shield.

8. The integrated circuit of claim 6 or 7, further comprising clock line side shields coupled to the Vss trace of the inductor side shield.

9. A device, comprising:
an integrated circuit including:
a substrate;
core logic circuitry disposed on the substrate;
a plurality of phase-locked loops (PLLs); and
clock routing circuits onfigured to provide PLL signals to channel clock generating circuitry;
wherein at least one of the clock routing circuits comprises:
a first inductor trace and a second inductor trace arranged in a spiral configuration and disposed in a first metal layer;
a first clock line coupled to the first inductor trace and a second clock line coupled to the second inductor trace, wherein the first clock line and second clock line are disposed in a second metal layer; and
a crossing region where the first clock line and the second clock line extend under the first and second inductor traces.

10. The device of claim 9, wherein:
the first inductor trace and the second inductor trace cross each other within the crossing region;
a first via couples the first inductor trace from the first metal layer to the second metal layer;
the portion of the first inductor trace in the second metal layer passes under the second inductor trace in the first metal layer; and
a second via couples the first inductor trace from the second metal layer to the first metal layer.

11. The device of claim 9 or 10, wherein:
the first clock line and the second clock line comprise widened portions within the crossing region; and
the first and second via are between the widened portions of the first clock line and the second clock line.

12. The device of any preceding claim 9 to 11, wherein:
the first inductor trace and the second inductor trace include a central region;
the first clock line and the second clock line extend under the central region;
the first inductor trace and the second inductor trace are positioned within the central region; and
there is no overlap between the first inductor trace and the second inductor trace and the first clock line and the second clock line within the central region.

13. A non-transitory computer-readable medium comprising stored instructions to manufacture a circuit, the circuit comprising:
a first inductor trace and a second inductor trace arranged in a spiral configuration and disposed in a first metal layer;
a first clock line coupled to the first inductor trace and a second clock line coupled to the second inductor trace, wherein the first clock line and second clock line are disposed in a second metal layer; and
a crossing region where the first clock line and the second clock line extend under the first and second inductor traces.

14. The non-transitory computer-readable medium of claim 13, wherein:
the first inductor trace and the second inductor trace cross each other within the crossing region;
a first via couples the first inductor trace from the first metal layer to the second metal layer;
a portion of the first inductor trace in the second metal layer passes under the second inductor trace in the first metal layer;
a second via couples the first inductor trace from the second metal layer to the first metal layer;
the first clock line and the second clock line comprise widened portions within the crossing region; and
the first and second via are between the widened portions of the first clock line and the second clock line.

15. The non-transitory computer-readable medium of claim 13 or 14, wherein:
the first inductor trace and the second inductor trace include a central region;
the first clock line and the second clock line extend under the central region;
the first inductor trace and the second inductor trace are positioned within the central region; and
there is no overlap between the first inductor trace and the second inductor trace and the first clock line and the second clock line within the central region.
